**Europäisches Patentamt**

(19) **European Patent Office**

**Office européen des brevets**

(11) Publication number : **0 643 417 A2**

(12) # EUROPEAN PATENT APPLICATION

(21) Application number : **94306395.8**

(22) Date of filing : **31.08.94**

(51) Int. Cl.$^6$ : **H01L 21/3215, H01L 21/336, H01L 21/265, H01L 21/28**

(30) Priority : **08.09.93 US 118540**

(43) Date of publication of application :
**15.03.95 Bulletin 95/11**

(84) Designated Contracting States :
**DE ES FR GB**

(71) Applicant : **AT & T Corp.**
**32 Avenue of the Americas**
**New York, NY 10013-2412 (US)**

(72) Inventor : **Lee, Kuo-Hua**
**1308 Country Club Road**
**Wescosville, Pennsylvania 18106 (US)**
Inventor : **Yu, Chen-Hua Douglas**
**1019 Hillview Drive**
**Allentown, Pennsylvania 18103 (US)**

(74) Representative : **Watts, Christopher Malcolm**
**Kelway, Dr. et al**
**AT&T (UK) Ltd.**
**5, Mornington Road**
**Woodford Green Essex, IG8 0TU (GB)**

(54) **Method of gate implantation.**

(57) A method for forming silicon integrated circuits is disclosed. Ion implantation of polysilicon gates is accomplished by directing a dopant species (21) at a polysilicon layer (19) at an angle instead of normal incidence. The angularly directed dopant species cannot channel through the polysilicon layer and, furthermore, the dopant species "sees" a thicker effective polysilicon layer (19).

*FIG. 1*

EP 0 643 417 A2

## Technical Field

This invention relates to methods of integrated circuit fabrication.

## Background of the Invention

Typical silicon MOSFET integrated circuits utilize gates made from doped polysilicon. A popular method for doping the polysilicon material employed in gates is ion implantation. However, in ion implantation, typically, the ions strike the polysilicon surface at normal incidence. There is a danger that the ions may traverse the polysilicon (and the underlying gate oxide) and embed themselves in the silicon substrate. The embedded ions adversely affect the channel of the subsequently-formed transistor.

Designers have attempted to alleviate this problem by making the polysilicon layer fairly thick, for example, between 300 and 500nm (3000 and 5000Å), depending on the implant energy. (Another approach has been to lower the implant energy. However, this approach causes throughput problems.) However, the thick polysilicon layer produces a gate stack which is undesirably high for sub-micron integrated circuits. The high gate stack produces an undesirably variable topography. Furthermore, the columnar structure of the polysilicon in the gate permits implantation ions to pass through even a relatively thick polysilicon layer and embed in the underlying substrate (thereby adversely affecting transistor performance). This phenomenon is often termed "channeling".

## Summary of the Invention

Lower gate stack heights are achievable with the present invention which illustratively includes forming a silicon layer upon a dielectric layer upon a substrate. Then a dopant species is directed at the silicon layer at a non-zero angle from normal. Then the gate is patterned.

## Brief Description of the Drawings

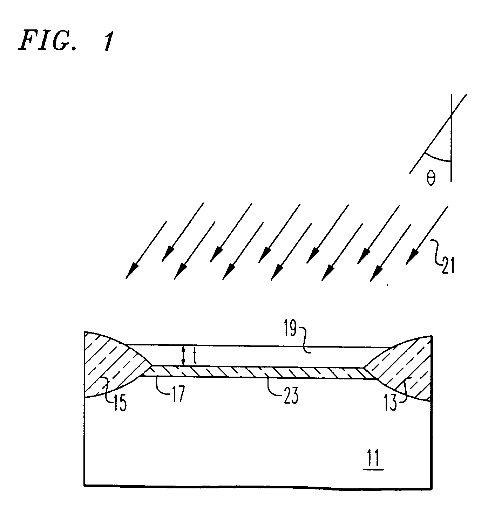

The figure is a cross-section of drawing useful in understanding an illustrative embodiment of the present invention.

## Detailed Description

In the figure reference numeral 11 denotes a substrate which may, illustratively, be silicon, doped silicon, or epitaxial silicon. In general, the term substrate refers to a material upon which other material layers may be deposited or formed. Reference numerals 13 and 15 denote a field oxide which may, for example, be formed by the LOCOS or poly buffered LOCOS processes.

Reference numeral 17 denotes a gate oxide layer formed over surface 23 of substrate 11. Reference numeral 19 denotes a polysilicon layer.

It is desirable to implant polysilicon layer 19 with dopant ions to reduce its sheet resistance and achieve a desirable work function for the transistor gate. In previous practice, the thickness of layer 19 was typically between 300nm (3000Å) and 500nm (5000Å) (to alleviate the problems mentioned above). However, in an illustrative embodiment of the present invention, the thickness of layer 19 may be between 50nm (500Å) and 200nm (2000Å).

Reference numeral 21 denotes dopant ion species, such as boron, or $BF_2$, or phosphorus, or arsenic directed at polysilicon layer 19. However, unlike previous practice, dopant ions 21 are not normally incident upon polysilicon layer 19. Instead, dopant ions 21 are directed at comparatively large angle $\theta$ from normal towards polysilicon layer 19. Angles between 20° and 80° are most desirable. (Some manufacturers currently perform implants, such as source-drain into silicon substrates at low angles of 7°.) The angular implantation of dopant ions 21 avoids the possibility that the dopants 21 may be channeled by the columnar structure of polysilicon 19. During the implantation step, the wafer is rotated to prevent shadowing. Furthermore, dopant ions 21 see a greater effective distance within polysilicon layer 19. For example, if the thickness of layer 19 is t, a dopant ion 21 must traverse a distance given by equation (1) below.

$$d = \frac{t}{\cos\theta} \quad (1)$$

Thus, the inventive procedure creates the larger effective "gate thickness" for dopant ions 21 to traverse. Typical desirable ion implantation energies and doses for boron are: 5-10 Kev; for $BF_2$ are 15-40 Kev; for phosphorus are 15-30 Kev; and for arsenic are 20-50 Kev, with doses of $10^{15}$-$10^{16}$/cm$^2$ for each species (for the polysilicon thickness given previously).

Conventional semiconductor integrated circuit processing may proceed at this point, including gate definition by etching layers 19 and 23, source, drain definition, etc.

## Claims

1. A method of semiconductor integrated circuit fabrication comprising:

    forming a dielectric layer (17) upon a substrate (11);

    forming a silicon layer (19) upon said dielectric layer (17);

    directing a dopant species (21) at said silicon layer (19) and

    patterning said silicon layer (19) to form a gate,

CHARACTERIZED IN THAT
said dopant species (21) is directed at a non-zero angle measured from normal.

2. The method of claim 1 in which said silicon layer (19) is polysilicon.

3. The method of claim 1 or claim 2 in which said dielectric layer (17) is silicon dioxide.

4. The method of any of the preceding claims in which said dopant species (21) is chosen from the group consisting of boron, $BF_2$, phosphorus, and arsenic.

5. The method of any of the preceding claims in which said angle is between 20° and 80°.

6. The method of any of the preceding claims in which the thickness of said silicon layer (19) is between 50nm and 200nm.

## FIG. 1